# EUROPEAN PATENT APPLICATION

(11) **EP 4 451 313 A1**
(43) Date of publication of application: **23.10.2024**
(21) Application number: 22907138.6
(22) Date of filing: 21.11.2022
(51) Int. Cl.: H01L 21/205

(54) **WAFER LIFT PIN AND SIC FILM-COATED GLASSY CARBON MATERIAL**

(30) Priority: 13.12.2021 JP 2021201511
(71) Applicant: Tokai Carbon Co., Ltd., Minato-ku Tokyo 107-8636 (JP)
(72) Inventor: TOKUNAGA, Takeshi, Tokyo 107-8636 (JP); YAMAGUCHI, Yoshihiro, Tokyo 107-8636 (JP)
(74) Representative: Müller-Boré & Partner Patentanwälte PartG mbB
(86) International application number: PCT/JP2022/042965
(87) International publication number: WO 2023/112607

(57) **Abstract**

A wafer lift pin that is inserted in an insertion hole of a susceptor in a semiconductor production apparatus so as to be movable in a vertical direction and is used for lifting a silicon wafer placed on the susceptor includes: a rod-shaped base material made from glassy carbon; and an SiC film that is formed by a CVD method and coats a surface of the base material, wherein at least a sliding portion with an inner side of the insertion hole of the susceptor is coated with the SiC film; when the surface of the SiC film is observed with a scanning electron microscope, the surface of the wafer lift pin in an observation visual field is entirely coated with SiC particles, and a ratio of an observed area of small SiC particles having a particle diameter of 2.00 µm or smaller to a total area coated with the SiC film in the observation visual field is 50% or more; and a portion abutting against the silicon wafer is not coated with the SiC film. According to the present invention, there can be provided a wafer lift pin in which the cracking of the SiC film originating in the difference in the coefficient of thermal expansion between the SiC film and the glassy carbon resists occurring when the formed SiC film is cooled.

## Description

### [Technical Field]

The present invention relates to an SiC film-coated glassy carbon material which is a heat-resistant member to be used in a raw-material gas atmosphere of a high temperature, such as a member of a semiconductor production apparatus, and in which a base material formed from glassy carbon is coated with an SiC film.

### [Background Art]

As a semiconductor production apparatus, there is a semiconductor production apparatus, for example, which performs epitaxial growth treatment on a silicon wafer. In the semiconductor production apparatus that performs the epitaxial growth treatment, a silicon wafer to be treated is placed on a susceptor, and a wafer lift pin is held in an insertion hole of the susceptor in such a form that an upper end of the lift pin abuts against a lower surface of the silicon wafer when the wafer is installed, and the wafer lift pin is suspended from the susceptor during a reaction.

Then, in the epitaxial growth treatment, the apparatus heats the silicon wafer by a heating lamp while rotating the susceptor and supplying a raw material gas thereinto; and thereby, the raw material gas reacts on the silicon wafer, and the silicon wafer is subjected to the epitaxial growth treatment. After the treatment, the apparatus stops the rotation of the susceptor, pushes the wafer lift pin upward, and thereby uplifts the silicon wafer from the susceptor; and next, the apparatus inserts a hand for carrying out the silicon wafer between the silicon wafer and the susceptor, then, lowers the wafer lift pin downward, and places the silicon wafer on the hand. Next, the apparatus pulls the hand out from its inside, and thereby carries the silicon wafer after the treatment out from the apparatus.

In the semiconductor production apparatus for performing the epitaxial growth treatment, it is necessary to perform the reaction of the raw material gas at a high temperature during the treatment, but there is a problem that the wafer lift pin serves as a heat escape path, heat escapes via the wafer lift pin, as a result, temperature variation occurs in the wafer surface, which causes non-uniformity in a plane of a film to be formed, and finally results in affecting the product quality and yield.

Because of this, it is necessary to use a material having low thermal conductivity for the wafer lift pin. Here, as the material having the low thermal conductivity, glassy carbon is known. However, the wafer lift pin moves up and down in a state of being inserted in the susceptor, and accordingly causes a problem that the side surface of the wafer lift pin slides on the inner side of the insertion hole of the susceptor during the vertical movement, and at the time, wearing out of the glassy carbon results.

For this reason, as a wafer lift pin in which glassy carbon prevents wear, for example, Patent Literature 1 discloses a wafer lift pin in which a base material made from glassy carbon is coated with diamond-like carbon (DLC), in the Example.

### [Citation List]

### [Patent Literature]

[Patent Literature 1]
Japanese Patent Laid-Open No. 2016-92129

### [Disclosure of the Invention]

### [Technical Problem]

However, the diamond-like carbon has problems that the difficulty of film formation itself is high, and the hardness of the film is high, which may wear out the susceptor.

Conventionally, it has been conducted to form and deposit a uniform and dense SiC coating on a surface of a carbonaceous material by a CVD method, so as to impart oxidation resistance to the carbonaceous material, and for example, a heat-resistant material in which an SiC coating is formed on the surface of a graphite material by a CVD method has been used in a wide range of application fields. The formation of the SiC film can prevent volatilization of impurities in the carbon base material, and accordingly, is considered to be useful also for a member of a semiconductor production apparatus which requires high purity. In addition, the SiC film is formed from the same material as that of the surface of the susceptor, which is generally used, and has the same hardness as that of the surface of the susceptor; and accordingly, even when the SiC film slides on the inner side of the insertion hole of the susceptor when the wafer lift pin moves vertically, the SiC film resists being worn, and also, the problem of the diamond-like carbon as described above does not occur. For this reason, as a substance for coating the base material made from glassy carbon, an SiC film becomes a candidate.

However, there is a large difference in a coefficient of thermal expansion between the SiC film and the glassy carbon; and accordingly, even if the SiC film is tried to be formed on the glassy carbon material according to a conventional technique, the coating cannot be kept, because when the SiC film is formed on the glassy carbon and then cooled to room temperature, a stress originating in the difference in the coefficient of thermal expansion acts strongly and generation of cracks and peeling in the film results. Specifically, such a new problem arises that the SiC film results in being cracked.

Such a problem that cracks and peeling occur after the SiC film has been formed due to a large difference in the coefficient of thermal expansion between the SiC film and the glassy carbon is not limited to the wafer lift pin, but is common to the glassy carbon material coated with the SiC film.

Accordingly, an object of the present invention is to provide a wafer lift pin in which the cracking and peeling of the SiC film originating in the difference in the coefficient of thermal expansion between the SiC film and the glassy carbon resist occurring, when the SiC film is formed. In addition, another object of the present invention is to provide the SiC film-coated glassy carbon material in which cracking of the SiC film originating in the difference in the coefficient of thermal expansion between the SiC film and the glassy carbon resists occurring, after the SiC film has been formed.

### [Solution to Problem]

In view of the above technical background, the present inventors have conducted intensive studies, and have found that an SiC film-coated glassy carbon material in which the cracking of the SiC film resists occurring after the SiC film has been formed, which originates in a difference in the coefficient of thermal expansion between the SiC film and the glassy carbon, can be obtained by adjusting the particle size of SiC particles which form the SiC film, by adjustment of a treatment temperature and time period, when the SiC film is formed by a CVD method on a base material made from the glassy carbon.

In other words, the present invention (1) is a wafer lift pin that is inserted in an insertion hole of a susceptor in a semiconductor production apparatus so as to be movable in a vertical direction, and is used for lifting a silicon wafer placed on the susceptor, including:
a rod-shaped base material made from glassy carbon; and an SiC film that is formed by a CVD method and coats a surface of the base material, wherein
at least a sliding portion with an inner side of the insertion hole of the susceptor is coated with the SiC film;
when a surface of the SiC film is observed with a scanning electron microscope, a surface of the wafer lift pin in an observation visual field is entirely coated with SiC particles, and a ratio of an observed area of small SiC particles having a particle diameter of 2.00 µm or smaller to a total area coated with the SiC film in the observation visual field is 50% or more; and
a portion abutting against the silicon wafer is not coated with the SiC film.

In addition, the present invention (2) provides the wafer lift pin according to (1), wherein the small SiC particles have an average particle diameter of 0.60 to 1.60 µm, and a standard deviation of the particle diameters is 0.20 µm or smaller.

In addition, the present invention (3) provides the wafer lift pin according to (1) or (2), wherein the SiC film has a thickness of 3.0 to 10.0 µm.

In addition, the present invention (4) provides the wafer lift pin according to any one of (1) to (3), wherein in the SiC film, a ratio of an observed area of the small SiC particles to a total area coated with the SiC film on a side abutting against the silicon wafer is larger than a ratio of the observed area of the small SiC particles to a total area coated with the SiC film on a side opposite to the side abutting against the silicon wafer.

In addition, the present invention (5) provides the wafer lift pin according to any one of (1) to (4), wherein in the SiC film, the SiC film on the side abutting against the silicon wafer is thinner than the SiC film on the side opposite to the side abutting against the silicon wafer.

In addition, the present invention (6) provides a wafer lift pin that is inserted in an insertion hole of a susceptor in a semiconductor production apparatus so as to be movable in a vertical direction, and is used for lifting a silicon wafer placed on the susceptor, including:
a rod-shaped base material made from glassy carbon; and an SiC film that is formed by a CVD method and coats a surface of the base material, wherein
at least a sliding portion with an inner side of the insertion hole of the susceptor is coated with the SiC film;
the SiC film has a thickness of 3.0 to 10.0 µm; and
a portion abutting against the silicon wafer is not coated with the SiC film.

In addition, the present invention (7) provides the wafer lift pin according to (6), wherein in the SiC film, the SiC film on a side abutting against the silicon wafer is thinner than the SiC film on a side opposite to the side abutting against the silicon wafer.

In addition, the present invention (8) provides an SiC film-coated glassy carbon material including: a base material made from glassy carbon; and an SiC film that is formed by a CVD method and coats a surface of the base material, wherein
when a surface of the SiC film is observed with a scanning electron microscope, the surface of the base material in an observation visual field is entirely coated with SiC particles, and a ratio of an observed area of small SiC particles having a particle diameter of 2.00 µm or smaller to a total area coated with the SiC film in the observation visual field is 50% or more.

In addition, the present invention (9) provides an SiC film-coated glassy carbon material including: a base material made from glassy carbon; and an SiC film that is formed by a CVD method and coats a surface of the base material, wherein
the SiC film has a thickness of 3.0 to 10.0 µm.

### [Advantageous Effects of Invention]

According to the present invention, there can be provided a wafer lift pin in which the cracking of the SiC film originating in the difference in the coefficient of thermal expansion between the SiC film and the glassy carbon resists occurring, when a temperature is returned to room temperature after the SiC film has been formed. In addition, according to the present invention, there can be provided an SiC film-coated glassy carbon material in which the cracking of the SiC film originating in the difference in the coefficient of thermal expansion between the SiC film and the glassy carbon resists occurring, when the temperature is returned to room temperature after the SiC film has been formed.

### [Brief Description of Drawings]

[Figure 1] Figure 1 shows a schematic view of a semiconductor production apparatus for performing epitaxial film-forming treatment on a silicon wafer.
[Figure 2] Figure 2 shows a schematic view showing a wafer lift pin according to an exemplary aspect of the present invention.
[Figure 3] Figure 3 shows an enlarged view of the wafer lift pin on a side abutting against the silicon wafer in Figure 2.
[Figure 4] Figure 4 shows an SEM photograph (5000 times) of an SiC film at a position of 5 mm distant from the side abutting against a silicon wafer of Example 1.
[Figure 5] Figure 5 shows an SEM photograph (5000 times) of the SiC film at a position of 25 mm distant from the side abutting against the silicon wafer of Example 1.

### [Description of Embodiments]

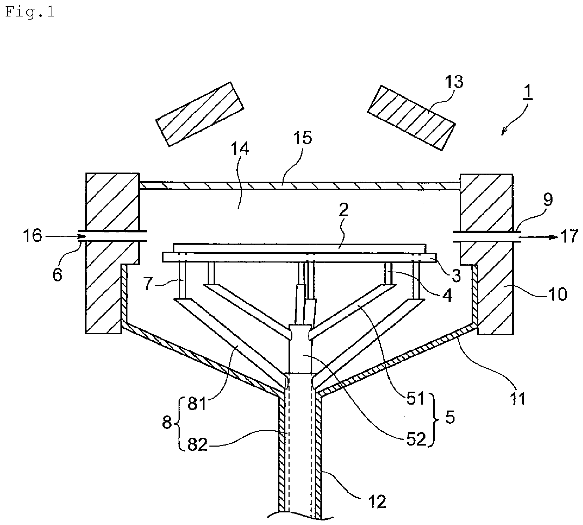

A semiconductor production apparatus that uses the wafer lift pin of the present invention will be described with reference to Figure 1. Figure 1 is a schematic view of the semiconductor production apparatus for performing epitaxial film-forming treatment on a silicon wafer. In Figure 1, the semiconductor production apparatus 1 includes a heating lamp 13, a side wall 10, an upper plate 15 that is affixed to the side wall 10 and is formed from a material through which heating light of the heating lamp 13 can pass, a lower outer wall 11 to which the side wall 10 is affixed, and an outer column 12 which supports the lower outer wall 11. In addition, a treatment chamber 14 for treating the silicon wafer is formed by being surrounded by the side wall 10, the upper plate 15 and the lower outer wall 11.

Furthermore, the semiconductor production apparatus 1 includes a susceptor 3, a susceptor support pin 4, and a susceptor support column 5. In the treatment chamber 14, the susceptor 3 is installed on which a silicon wafer 2 is placed during the treatment. The susceptor 3 is supported by susceptor support pins 4 of which the upper ends are each fixed to the susceptor 3, and of which the lower ends are also each fixed to the susceptor support column 5. A lower end side of the susceptor support pin 4 is fixed to a pin receiving portion 51 of the susceptor support column 5, and a vertical portion 52 of the susceptor support column 5 is affixed to an inner side of an outer column 12 so as to be rotatable in the outer column 12. In addition, in the susceptor 3, insertion holes are formed through which wafer lift pins 7 are inserted so as to be vertically movable.

Furthermore, the semiconductor production apparatus 1 includes the wafer lift pins 7 and wafer lift support columns 8. The wafer lift pins 7 are inserted into the insertion holes that are formed in the susceptor 3, and are also installed in a state in which upper ends thereof abut against a lower surface of the silicon wafer 2. The lower end of the wafer lift pin 7 is fixed to a pin receiving portion 81 of the wafer lift support column 8, and a vertical portion 82 of the wafer lift support column 8 is affixed to the inner side of the outer column 12 so as to be rotatable and also vertically movable in the outer column 12.

Furthermore, in the semiconductor production apparatus 1, a supply pipe 6 for a raw material gas 16 and a discharge pipe 9 for an exhaust gas 17 are attached to the side wall 10.

During the treatment, the raw material gas 16 is supplied from the supply pipe 6 to the treatment chamber 14, and the silicon wafer 2 is heated by the heating lamp 13; thereby, a reaction of a reaction gas 16 occurs on a surface of the silicon wafer 2, and the surface of the silicon wafer 2 is treated. Then, the raw material gas 16 is supplied from the supply pipe 6 to the treatment chamber 14, and the exhaust gas 17 which is generated by the reaction of the raw material gas 16 is discharged from the exhaust pipe 9.

In addition, during the treatment, the semiconductor production apparatus 1 rotates the susceptor support column 5 and the wafer lift support column 8 together in the outer column 12 to rotate the silicon wafer 2, and thereby performs uniform treatment onto the silicon wafer 2.

Then, after having treated the silicon wafer 2, the apparatus stops the rotation of the susceptor support column 5 and the wafer lift support column 8. Subsequently, the wafer lift support column 8 is moved upward, and thereby, the wafer lift pins 7 push up the silicon wafer 2, and form a gap between the silicon wafer 2 and the susceptor 3. Subsequently, the apparatus inserts a hand for carrying out the silicon wafer between the silicon wafer 2 and the susceptor 3, then moves the wafer lift support column 8 downward to lower the wafer lift pins 7 downward, and thereby places the silicon wafer 2 on the hand. Next, the apparatus pulls the hand out from its inside, and thereby carries the silicon wafer 2 after the treatment out from the apparatus.

At this time, during the treatment, heat of the silicon wafer 2 is conducted to the wafer lift support column 8 via the wafer lift pin 7, and escapes to the outside of the apparatus. In addition, when the silicon wafer 2 is taken out of the apparatus after the treatment, the wafer lift pins 7 move up and down in the insertion holes of the susceptor 3, and accordingly slide with the inner side of the insertion holes. For these reasons, it is required for the wafer lift pin to be low in thermal conductivity and also excellent in wear resistance.

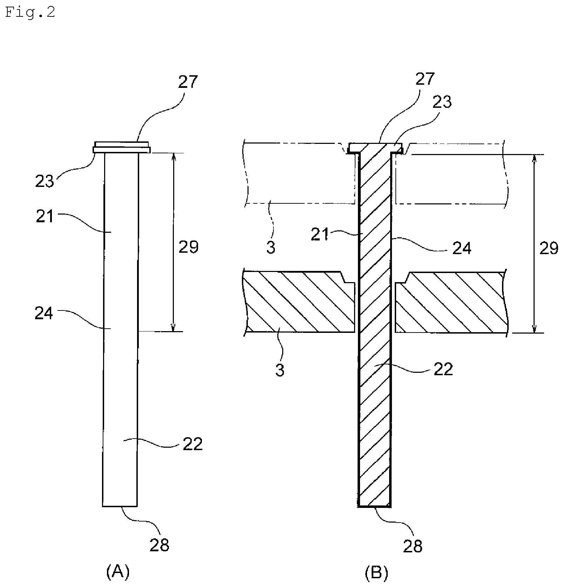

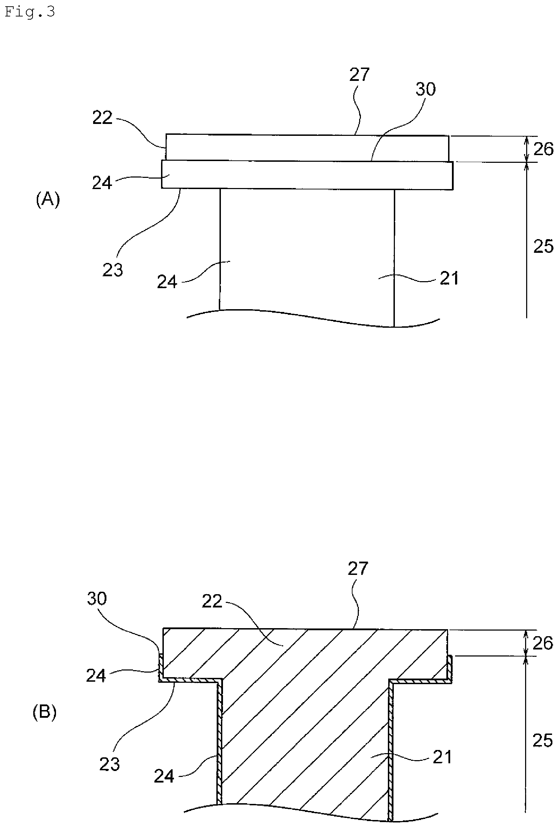

The wafer lift pin will be described below with reference to Figure 2 and Figure 3. Figure 2 is a schematic view showing a wafer lift pin according to an exemplary aspect of the present invention; and Figure 2(A) is a side view and Figure 2(B) is an end view. Figure 3 is an enlarged view of the wafer lift pin on a side abutting against the silicon wafer in Figure 2; and (A) is a side view and (B) is an end view. In Figure 2 and Figure 3, a wafer lift pin 21 includes: a rod-shaped base material 22 that has a head portion 23 for abutment projecting outward from the main body portion at the end of the side abutting against the silicon wafer; and an SiC film 24 that coats a surface of the base material 22. The base material 22 is made from the glassy carbon. In addition, the SiC film 24 is formed by a CVD method. In addition, in the wafer lift pin 21, a region denoted by reference numeral 25 is coated with the SiC film, but a portion 27 abutting against the silicon wafer and a vicinity thereof are not coated with the SiC film. In other words, in the wafer lift pin 21, a portion 26 uncoated with the SiC film is formed at the portion 27 abutting against the silicon wafer and in the vicinity thereof. In addition, a surface of the wafer lift pin 21 other than the portion 26 uncoated with the SiC film is coated with the SiC film, and a portion 25 coated with the SiC film is formed from a side 28 opposite to the side abutting against the silicon wafer to a boundary with the portion 26 uncoated with the SiC film. In addition, in Figure 2(B), the susceptor 3 is also shown; a position shown by a two-dot chain line (upper side) in (B) is a position of the susceptor 3 before the silicon wafer is uplifted, and a position indicated by the solid line (lower side) is a position of the susceptor 3 at the time when the silicon wafer has been uplifted; and accordingly, the wafer lift pin 21 existing in a range denoted by reference numeral 29 slides with the inner side of the insertion hole of the susceptor 3. In other words, a portion of the wafer lift pin in the range denoted by reference numeral 29 is a sliding portion 29. In addition, in the wafer lift pin 21, the entire sliding portion 29 is coated with the SiC film.

A wafer lift pin according to a first aspect of the present invention is a wafer lift pin that is inserted in an insertion hole of a susceptor in a semiconductor production apparatus so as to be movable in a vertical direction, is used for lifting a silicon wafer placed on the susceptor, and includes:
a rod-shaped base material made from glassy carbon; and an SiC film that is formed by a CVD method and coats a surface of the base material, wherein
at least a sliding portion with an inner side of the insertion hole of the susceptor is coated with the SiC film;
when the surface of the SiC film is observed with a scanning electron microscope, a surface of the wafer lift pin in an observation visual field is entirely coated with SiC particles, and a ratio of an observed area of small SiC particles having a particle diameter of 2.00 µm or smaller to a total area coated with the SiC film in the observation visual field is 50% or more; and
a portion abutting against the silicon wafer is not coated with the SiC film.

A wafer lift pin according to a second aspect of the present invention is a wafer lift pin that is inserted in an insertion hole of a susceptor in a semiconductor production apparatus so as to be movable in a vertical direction, is used for lifting a silicon wafer placed on the susceptor, and includes:
a rod-shaped base material made from glassy carbon; and an SiC film that is formed by a CVD method and coats a surface of the base material, wherein at least a sliding portion with an inner side of the insertion hole of the susceptor is coated with the SiC film; the SiC film has a thickness of 3.0 to 10.0 µm; and
a portion abutting against the silicon wafer is not coated with the SiC film.

Note that when the wafer lift pin of the first aspect of the present invention and the wafer lift pin of the second aspect of the present invention have common features, the wafer lift pins will be collectively referred to as the wafer lift pin of the present invention.

The wafer lift pin of the present invention is a member which is inserted into an insertion hole of a susceptor in the semiconductor production apparatus for performing treatment such as epitaxial film formation on a silicon wafer, so as to be movable in a vertical direction. In addition, the wafer lift pin of the present invention is a rod-shaped member for lifting the silicon wafer which is placed on the susceptor, by being uplifted upward in the insertion hole of the susceptor, when the silicon wafer after the treatment is taken out to the apparatus.

The wafer lift pin of the present invention includes: a rod-shaped base material made from glassy carbon; and an SiC film that is formed by a CVD method and coats a surface of the base material. In the wafer lift pin of the present invention, at least the sliding portion that slides with the inner side of the insertion hole of the susceptor in the rod-shaped base material made from the glassy carbon is coated with the SiC film which is formed by the CVD method.

The material of the rod-shaped base material is the glassy carbon. The glassy carbon refers to carbon that is obtained by molding a thermosetting resin such as a furan resin or a phenol resin, and then firing the resin. The thermal conductivity of the glassy carbon is lower than that of graphite, and accordingly, when the base material of the wafer lift pin is made from the glassy carbon, the wafer lift pin resists escaping of the heat of the silicon wafer to the outside by thermal conduction, even when abutting against the silicon wafer during the treatment in the semiconductor production apparatus.

The thermal conductivity of the glassy carbon constituting the base material is preferably 3 to 17 W/mK, and is particularly preferably 5 to 9 W/mK. In addition, other physical properties of the glassy carbon constituting the base material are not particularly limited, but the bulk density is preferably 1.43 to 1.53 g/cm³, the strength is preferably 49 to 118 MPa, and the roughness Ra is preferably 0.100 to 15.0 µm.

A shape of the base material is not particularly limited as long as the shape is such a rod shape that the upper end abuts against the lower surface of the silicon wafer, and the base material can be inserted into the insertion hole formed in the susceptor, and when a force has been applied upward from the lower end side, can move upward to uplift the silicon wafer. A shape of a cross section of the base material which has been cut along a plane perpendicular to a stretching direction is preferably circular, but may be elliptical, hollow, or the like, and may have a notch or the like as required. In addition, a main body portion extending in a rod shape of the base material may have a head portion for abutment on its upper end, which projects outward from the main body portion.

In the wafer lift pin of the present invention, a part of the surface of the rod-shaped base material is coated with the SiC film which has been formed by the CVD method. In the present invention, the CVD method means a method for depositing SiC on a surface of an object to be treated and coating the surface of the object to be treated with an SiC film, by a process of using a halogenated organic silicon compound containing an Si atom and a C atom in one molecule, for example, trichloromethylsilane (CH₃SiCl₃), dichloromethylsilane (CH₃SiHCl₂), trichlorophenylsilane (C₆H₅SiCl₃) or the like, as a raw material gas, supplying the raw material gas into a reaction apparatus together with hydrogen gas of a career gas, and making the raw material gas to cause vapor phase reduction and thermal decomposition, or by a process of using a silicon compound such as silicon tetrachloride (SiCl₄) and a carbon-containing compound such as methane (CH₄) as raw material gases, supplying the raw material gases into a reaction apparatus together with hydrogen gas or argon gas of a carrier gas, and making the gases to cause a vapor-phase reaction.

In the wafer lift pin of the present invention, at least a portion that slides with the inner side of the insertion hole formed in the susceptor, specifically, a sliding portion needs to be coated with the SiC film. In the case where the sliding portion of the wafer lift pin, which slides with the inner side of the insertion hole formed in the susceptor, is coated with the SiC film, it becomes possible to prevent the wear of the pin which may be caused by the sliding of the side portion of the wafer lift pin with the inner side of the insertion hole of the susceptor, or to significantly reduce an amount of wear, when the silicon wafer is uplifted by the wafer lift pin in order to be taken out the silicon wafer from the semiconductor production apparatus. In addition, in the wafer lift pin of the present invention, the portion of the base material (end portion of abutting side) abutting against the silicon wafer and the vicinity thereof are not coated with the SiC film. In other words, in the wafer lift pin of the present invention, the portion uncoated with the SiC film is formed on the side abutting against the silicon wafer, and the entire portion of the contact surface coming in contact with the silicon wafer is uncoated with the SiC film. In other words, in the wafer lift pin of the present invention, at least the portion abutting against the silicon wafer (the contact surface coming in contact with the silicon wafer) is not coated with the SiC film. In addition, in the wafer lift pin of the present invention, as for the surface of the wafer lift pin other than the portion uncoated with the SiC film, at least the sliding portion may be coated with the SiC film; and it is appropriately selected depending on a thickness of the susceptor, an uplifting distance of the silicon wafer, a method of forming the SiC film, and the like, to which position the wafer lift pin is coated with the SiC film from the end of the sliding portion on the side opposite to the side abutting against the silicon wafer to the direction opposite to the side abutting against the silicon wafer. For example, the sliding portion and a portion from the end of the sliding portion on the side opposite to the side abutting against the silicon wafer to a middle of the sliding portion to the end on the side opposite to the side abutting against the silicon wafer may be coated with the SiC film; or, the sliding portion and a portion from the end of the sliding portion on the side opposite to the side abutting against the silicon wafer to the end opposite to the side abutting against the silicon wafer may be coated with the SiC film. In the wafer lift pin of the present invention, at least the portion abutting against the silicon wafer is not coated with the SiC film, and thereby, the portion coming in contact with the silicon wafer is not a hard SiC film but becomes glassy carbon; and accordingly, it becomes possible for the wafer lift pin to uplift the silicon wafer without causing a damage on the silicon wafer.

In the wafer lift pin of the first aspect of the present invention, when the surface of the SiC film is observed with a scanning electron microscope, the surface of the wafer lift pin in an observation visual field is entirely coated with SiC particles, and a ratio of an observed area of small SiC particles having a particle diameter of 2.00 µm or smaller to a total area coated with the SiC film in the observation visual field is 50% or more and is preferably 70% or more.

In the wafer lift pin according to the first aspect of the present invention, when the surface of the SiC film of the portion coated with the SiC film is observed with a scanning electron microscope (SEM), the entire surface of the wafer lift pin in an observation visual field is entirely coated with SiC particles. In addition, when the SiC film is observed with SEM, only small SiC particles having a particle diameter of 2.00 µm or smaller are observed, or small SiC particles having a particle diameter of 2.00 µm or smaller and large SiC particles having a particle diameter exceeding 2.00 µm are observed. In other words, in a portion coated with the SiC film of the wafer lift pin according to the first aspect of the present invention, the base material made from the glassy carbon is covered with small SiC particles, or with small SiC particles and large SiC particles. Note that if a portion uncoated with SiC particles exists on a surface of the base material made from the glassy carbon in the sliding portion which slides with the inner side of the insertion hole of the susceptor, it is not possible to prevent wear of the pin, which may occur when a side portion of the wafer lift pin slides with the inner side of the insertion hole of the susceptor.

In the wafer lift pin of the first aspect of the present invention, when the surface of the SiC film is observed with a scanning electron microscope, a ratio of an observed area of small SiC particles to a total area coated with the SiC film in the observation visual field is 50% or more and is preferably 70% or more. In the case where the ratio of the observed area of the small SiC particles to the total area coated with the SiC film in the observation visual field is in the above range, when the surface of the SiC film is observed with a scanning electron microscope, it is possible to prevent the wear of the pin which may be caused by the sliding of the side portion of the wafer lift pin with the inner side of the insertion hole of the susceptor, or to significantly reduce the amount of wear; and also to prevent the SiC film from cracking at the time when the formed film is cooled in the film formation by the CVD method, due to the difference in the coefficient of thermal expansion between the SiC film and the glassy carbon. On the other hand, when the surface of the SiC film is observed with a scanning electron microscope, if a ratio of the observed area of the small SiC particles to the total area coated with the SiC film in the observation visual field is less than the above range, cracks originating in the difference in the coefficient of thermal expansion between the SiC film and the glassy carbon are generated in the SiC film, in a cooling process after the SiC coating has been formed.

For information, if a reaction time is too short at the time when the SiC film is formed by the CVD method, a portion in which the SiC film is not formed or a portion in which the SiC film is disconnected occurs in a portion coated with the SiC film. Because of this, if the reaction time is too short at the time when the SiC film is formed by the CVD method, a portion that is not coated with the SiC film exists in the sliding portion which slides with the inner side of the insertion hole of the susceptor, and in the portion, the glassy carbon is exposed. Accordingly, the wafer lift pin of the present invention does not include a wafer lift pin in which a portion that is not coated with the SiC film exists in the sliding portion that slides with the inner side of the insertion hole of the susceptor; and in such a wafer lift pin, "the ratio of the observed area of the small SiC particles to the total area coated with the SiC film in the observation visual field, when the surface of the SiC film is observed with a scanning electron microscope" cannot be calculated.

The inventors of the present invention have studied a deposition process of SiC in the case where the SiC film is formed on the surface of the glassy carbon by a CVD method, and have found that in an initial stage of deposition of SiC, a large number of fine SiC particles adhere to the surface of the glassy carbon; furthermore, when a deposition reaction of SiC proceeds, there is a time when the entire surface of the glassy carbon is covered almost with fine SiC particles; when the deposition reaction of SiC further progresses from this state, coarse SiC particles begin to be observed, and as the deposition reaction of SiC progresses, the number of coarse SiC particles increases; and when the deposition reaction of SiC further proceeds, only coarse SiC particles come to be observed on an outer surface of the wafer lift pin. Furthermore, the present inventors have found that, when all or most of the SiC particles covering the surface of the base material made from the glassy carbon are fine SiC particles, the thermal stress is alleviated which may occur when the formed film is cooled and is caused by a difference in the coefficient of thermal expansion between the SiC film and the glassy carbon, and accordingly, cracking of the SiC film can be prevented; in other words, that the presence of the small SiC particles that coat the surface of the base material made from the glassy carbon gives a great influence on the alleviation of the thermal stress caused by the difference in the coefficient of thermal expansion between the SiC film and the glassy carbon. In addition, the present inventors have found that in a state in which a ratio of observed coarse SiC particles becomes too high, in the above deposition process of SiC, generation of cracking of the SiC film results, which may occur when the formed film is cooled, and originates in the difference in the coefficient of thermal expansion between the SiC film and the glassy carbon. The inventors of the present invention have found that in the case where the SiC film is formed on the surface of the glassy carbon by a CVD method, it is important to form such a state by appropriately selecting reaction conditions that the entire surface of the glassy carbon is covered almost with fine SiC particles, or such a state that a few number of coarse SiC particles and a large number of fine SiC particles are observed, in the above deposition process of SiC; in other words, it is important to form such a state that when the surface of the SiC film is observed by a scanning electron microscope, a ratio of the observed area of the small SiC particles to the total area coated with the SiC film in the observation visual field is 50% or more, and is preferably 70% or more; and accordingly the surface of the base material made from the glassy carbon is coated with the SiC film to such an extent that the wafer lift pin can prevent the wear of the pin, which may be caused by the sliding of the side portion thereof with the inner side of the insertion hole of the susceptor, or the amount of wear can significantly reduce the amount of the wear; and also, the cracking of the SiC film can be prevented, which may occur in the cooling process after the SiC coating has been formed and is caused by the difference in the coefficient of thermal expansion between the SiC film and the glassy carbon.

In the present invention, when the surface of the SiC film is observed with a scanning electron microscope, the ratio of the observed area of the small SiC particles to the total area coated with the SiC film in the observation visual field is determined by operations of: directly observing the surface of the formed SiC film with a scanning electron microscope at a magnification of 5000 times; measuring a total number of large particles having a particle diameter exceeding 2.00 µm; calculating an area of a circle which regards a size of the large particle as the diameter thereof; determining the totalized area to be the total area of the large particles exceeding 2.00 µm; and calculating a percentage of the total area of the large particles to the area of the observation visual field to obtain the area ratio of the large particles; and subtracting the calculated area ratio of the large particles from 100%. In other words, the ratio (%) of the observed area of the small SiC particles to the total area coated with the SiC film is a value calculated according to the following formula: ratio (%) of observed area of small SiC particles to total area coated with SiC film = 100-((total area of large particles / area of observation visual field) × 100) .

In the wafer lift pin according to the first aspect of the present invention, when the surface of the SiC film is observed with a scanning electron microscope, an average particle diameter of the small SiC particles is preferably 0.60 to 1.60 µm, and is particularly preferably 0.80 to 1.40 µm. In addition, the wafer lift pin of the first aspect of the present invention, when the surface of the SiC film is observed with a scanning electron microscope, the standard deviation of the particle diameters of the small SiC particles is preferably 0.20 µm or smaller, and is particularly preferably 0.10 µm or smaller. For information, in the calculations of the average particle diameter and the standard deviation of the small SiC particles, only SiC particles having a particle diameter of 2.00 µm or smaller, which are observed in the observation visual field, are used as target particles for the calculation of the average particle diameter and the standard deviation, and SiC particles having a particle diameter exceeding 2.00 µm are not included in the target particles for the calculation of the average particle diameter and the standard deviation. Then, when the average particle diameter and the standard deviation of the small SiC particles at the time when the surface of the SiC film is observed with a scanning electron microscope are in the above ranges, the effect of preventing the cracking of the SiC film is enhanced, which is caused by the difference in the coefficient of thermal expansion between the SiC film and the glassy carbon, when the formed film is cooled.

In the wafer lift pin of the first aspect of the present invention, it is preferable that the ratio of the observed area of the small SiC particles of the SiC film at the end portion on the side abutting against the silicon wafer and in the vicinity thereof to the total area coated with the SiC film is larger than the ratio of the area of the observed small SiC particles of the SiC film at the end portion on the side opposite to the side abutting against the silicon wafer and in the vicinity thereof to the total area coated with the SiC film, in such a point that the damage or the like onto the wafer can be prevented. For information, for example, in Figure 3, the end portion on the side abutting against the silicon wafer is a portion denoted by reference numeral 30, and the end portion on the side opposite to the side abutting against the silicon wafer is a portion denoted by reference numeral 28.

In the wafer lift pin of the first aspect of the present invention, the thickness of the SiC film is preferably 3.0 to 10.0 µm, and is particularly preferably 3.0 to 5.0 µm. When the thickness of the SiC film is within the above range, it is possible to prevent the wear of the wafer lift pin which may be caused by the sliding of the side portion of the wafer lift pin with the inner side of the insertion hole of the susceptor, or to significantly reduce the amount of wear; and also, the effect of preventing the cracking of the SiC film is enhanced, which may occur when the formed film is cooled and originates in the difference in the coefficient of thermal expansion between the SiC film and the glassy carbon.

For information, in the present invention, the particle diameters of the small SiC particles and the large SiC particles in the observation with a scanning electron microscope (SEM) refer to a length of the longest diameter of the particle image in the SEM image.

In the wafer lift pin according to the second aspect of the present invention, when the surface of the SiC film of the portion coated with the SiC film is observed with a scanning electron microscope (SEM), the entire surface of the wafer lift pin in the observation visual field is entirely coated with SiC particles. Note that if a portion uncoated with SiC particles exists on the surface of the base material made from the glassy carbon of the sliding portion which slides with the inner side of the insertion hole of the susceptor, it is not possible to prevent the wear of the pin, which may occur when the side portion of the wafer lift pin slides with the inner side of the insertion hole of the susceptor.

In the wafer lift pin of the second aspect of the present invention, the thickness of the SiC film is 3.0 to 10.0 µm, and is preferably 3.0 to 5.0 µm. When the thickness of the SiC film is within the above range, it is possible to prevent the wear of the wafer lift pin which may be caused by the sliding of the side portion of the wafer lift pin with the inner side of the insertion hole of the susceptor, or to significantly reduce the amount of wear, and also to prevent the cracking of the SiC film, which may occur when the formed film is cooled, and originates in the difference in the coefficient of thermal expansion between the SiC film and the glassy carbon. On the other hand, if the thickness of the SiC film is smaller than the above range, the coating of the base material made from the glassy carbon with the SiC film is insufficient, and accordingly, the base material made from the glassy carbon is worn by sliding with the inner side of the insertion hole of the susceptor as a result; and if the thickness exceeds the above range, generation of cracking of the SiC film results, which may occur when the formed film is cooled, and originates in the difference in the coefficient of thermal expansion between the SiC film and the glassy carbon.

In the present invention, the thickness of the SiC film is determined by operations of polishing the cross section and directly observing the polished cross section with a scanning electron microscope at a magnification of 1000 times or larger.

As described above, in the deposition process of SiC in the case where the SiC film is formed on the surface of the glassy carbon by a CVD method, when the entire surface of the glassy carbon is in such a state as to be covered almost with the fine SiC particles, or in such a state that a small number of coarse SiC particles and a large number of fine SiC particles are observed, the surface of the base material made from the glassy carbon is coated with the SiC film to such an extent that the wafer lift pin can prevent the wear of the pin, which may be caused by sliding of the side portion thereof with the inner side of the insertion hole of the susceptor or can significantly reduce the amount of the wear; and the cracking of the SiC film can also be prevented, which is caused by the difference in the coefficient of thermal expansion between the SiC film and the glassy carbon, in the cooling process after the SiC coating has been formed. In the above deposition process of SiC, if the process is in the state where the ratio of the area is too high in which the coarse SiC particles are observed, generation of cracks in the SiC film which originate in the difference in the coefficient of thermal expansion between the SiC film and the glassy carbon results, in the cooling process after the SiC coating has been formed. In addition, in the wafer lift pin of the second aspect of the present invention, in the case where the SiC film is formed on the surface of the glassy carbon by the CVD method, the entire surface of the glassy carbon can be controlled to such a state as to be covered almost with fine SiC particles or to such a state that a small number of coarse SiC particles and a large number of fine SiC particles are observed, in the above deposition process of SiC, by appropriately selecting the reaction conditions and adjusting the thickness of the SiC film of the portion coated with the SiC film to 3.0 to 10.0 µm, and preferably 3.0 to 5.0 µm; and accordingly the surface of the base material made from the glassy carbon is coated with the SiC film to such an extent that the wafer lift pin can prevent the wear of the pin, which may be caused by sliding of the side portion thereof with the inner side of the insertion hole of the susceptor, or can significantly reduce the amount of the wear; and the cracking of the SiC film can also be prevented, which is caused by the difference in the coefficient of thermal expansion between the SiC film and the glassy carbon, in the cooling process after the SiC coating has been formed.

In the wafer lift pin of the second aspect of the present invention, it is preferable that a thickness of the SiC film at the end portion on the side abutting against the silicon wafer and in the vicinity thereof, in the SiC film, is smaller than a thickness of the SiC film at the end portion on the side opposite to the side abutting against the silicon wafer and in the vicinity thereof, in such a point that the damage or the like onto the wafer can be prevented.

In the wafer lift pin of the present invention, the surface roughness Ra of the SiC film is preferably 0.100 to 5.00 µm, and is particularly preferably 0.100 to 2.00 µm. When the surface roughness Ra of the SiC film is in the above range, friction at the time of sliding with the susceptor can be reduced.

The coating form of the SiC film in the wafer lift pin of the present invention can be applied not only to the wafer lift pin coated with the SiC film, but also to other SiC film-coated glassy carbon materials which have the base material made from the glassy carbon and an SiC film that coats the surface of the base material. The application of the SiC film-coated glassy carbon material is not particularly limited, but examples thereof include a member that is used under a condition of an oxygen atmosphere and a high temperature, or under such a condition that the SiC film-coated glassy carbon material is repeatedly rubbed by a member having high hardness; and more specifically, include a member for a heater made from glassy carbon, in which the life end due to oxidation consumption when only glassy carbon is used could have been a problem hitherto, and a member for a semiconductor production apparatus which is used for a movable portion of a conveying tool or the like.

In other words, the SiC film-coated glassy carbon material according to the first aspect of the present invention includes: a base material made from glassy carbon; and an SiC film that is formed by a CVD method and coats a surface of the base material, wherein
when the surface of the SiC film is observed with a scanning electron microscope, the surface of the base material in an observation visual field is entirely coated with SiC particles, and a ratio of an observed area of small SiC particles having a particle diameter of 2.00 µm or smaller to a total area coated with the SiC film in the observation visual field is 50% or more.

In addition, the SiC film-coated glassy carbon material according to the second aspect of the present invention includes: a base material made from glassy carbon; and an SiC film that is formed by a CVD method and coats a surface of the base material, wherein
the SiC film has a thickness of 3.0 to 10.0 µm.

Note that when the SiC film-coated glassy carbon material of the first aspect of the present invention and the SiC film-coated glassy carbon material of the second aspect of the present invention have common features, the SiC film-coated glassy carbon materials will be collectively referred to as the SiC film-coated glassy carbon material of the present invention.

The material of the base material of the SiC film-coated glassy carbon material of the present invention is glassy carbon. The glassy carbon refers to carbon that is obtained by molding a thermosetting resin such as a furan resin or a phenol resin, and then firing the resin.

The thermal conductivity of the glassy carbon constituting the base material is preferably 3 to 17 W/mK, and is particularly preferably 5 to 9 W/mK. In addition, other physical properties of the glassy carbon constituting the base material are not particularly limited, but the bulk density is preferably 1.43 to 1.53 g/cm³, the strength is preferably 49 to 118 MPa, and the roughness Ra is preferably 0.100 to 5.00 µm.

The shape of the base material is appropriately selected according to the application.

In the SiC film-coated glassy carbon material of the present invention, the whole or a part of the surface of the base material is coated with the SiC film which has been formed by a CVD method. The CVD method for the SiC film-coated glassy carbon material of the present invention is the same as the CVD method for the wafer lift pin of the present invention.

In the SiC film-coated glassy carbon material according to the first aspect of the present invention, when the surface of the SiC film of the portion coated with the SiC film is observed with a scanning electron microscope, a surface of the base material in an observation visual field is entirely coated with SiC particles; and a ratio of an observed area of small SiC particles having a particle diameter of 2.00 µm or smaller to a total area coated with the SiC film in the observation visual field is 50% or more and is preferably 70% or more.

In the SiC film-coated glassy carbon material according to the first aspect of the present invention, when the surface of the SiC film of the portion coated with the SiC film is observed with a scanning electron microscope (SEM), the entire surface of the glassy carbon material in an observation visual field is entirely coated with SiC particles. In addition, when the SiC film is observed with SEM, only small SiC particles having a particle diameter of 2.00 µm or smaller are observed, or small SiC particles having a particle diameter of 2.00 µm or smaller and large SiC particles having a particle diameter exceeding 2.00 µm are observed. In other words, in the SiC film-coated glassy carbon material according to the first aspect of the present invention, the base material made from the glassy carbon is covered with small SiC particles, or with small SiC particles and large SiC particles. Note that if there is a portion that is not coated with the SiC particles on the surface of the base material made from the glassy carbon, the coating effect of the SiC film cannot be obtained.

In the SiC film-coated glassy carbon material of the first aspect of the present invention, when the surface of the SiC film is observed with a scanning electron microscope, a ratio of an observed area of small SiC particles to a total area coated with the SiC film in the observation visual field is 50% or more and is preferably 70% or more. In the case where, when the surface of the SiC film is observed with a scanning electron microscope, the ratio of the observed area of the small SiC particles to the total area coated with the SiC film in the observation visual field is in the above range, the coating effect by the SiC film is obtained; and the cracking of the SiC film can also be prevented, which may occur when the formed film is cooled, and originates in the difference in the coefficient of thermal expansion between the SiC film and the glassy carbon. On the other hand, when the surface of the SiC film is observed with a scanning electron microscope, if a ratio of the observed area of the small SiC particles to the total area coated with the SiC film in the observation visual field is less than the above range, generation of cracks in the SiC film which originate in the difference in the coefficient of thermal expansion between the SiC film and the glassy carbon results, when the formed film is cooled.

For information, if a reaction time is too short at the time when the SiC film is formed by the CVD method, a portion in which the SiC film is not formed occurs in an SiC-coated portion. Accordingly, the SiC film-coated glassy carbon material of the present invention does not include an SiC film-coated glassy carbon material in which a portion that is not coated with the SiC film exists in the portion coated with SiC; and in such an SiC film-coated glassy carbon material, "the ratio of the observed area of the small SiC particles to the total area coated with the SiC film in the observation visual field, when the surface of the SiC film is observed with a scanning electron microscope" cannot be calculated.

In the SiC film-coated glassy carbon material according to the first aspect of the present invention, when the surface of the SiC film is observed with a scanning electron microscope, an average particle diameter of the small SiC particles is preferably 0.60 to 1.60 µm, and is particularly preferably 0.80 to 1.40 µm. In addition, in the SiC film-coated glassy carbon material of the first aspect of the present invention, when the surface of the SiC film is observed with a scanning electron microscope, the standard deviation of the particle diameters of the small SiC particles is preferably 0.20 µm or smaller, and is particularly preferably 0.10 µm or smaller. For information, in the calculations of the average particle diameter and the standard deviation of the small SiC particles, only SiC particles having a particle diameter of 2.00 µm or smaller, which are observed in the observation visual field, are used as target particles for the calculation of the average particle diameter and the standard deviation, and SiC particles having a particle diameter exceeding 2.00 µm are not included in the target particles for the calculation of the average particle diameter and the standard deviation. Then, when the average particle diameter and the standard deviation of the small SiC particles at the time when the surface of the SiC film is observed with a scanning electron microscope are in the above ranges, the effect of preventing the cracking of the SiC film is enhanced, which is caused by the difference in the coefficient of thermal expansion between the SiC film and the glassy carbon, when the formed film is cooled.

In the SiC film-coated glassy carbon material of the second aspect of the present invention, the thickness of the SiC film of the portion coated with the SiC film is 3.0 to 10.0 µm, and is preferably 3.0 to 5.0 µm. When the thickness of the SiC film of the portion coated with the SiC film is within the above range, the coating effect by the SiC film can be appropriately obtained, and the cracking of the SiC film can also be prevented, which may occur when the formed film is cooled, and originates in the difference in the coefficient of thermal expansion between the SiC film and the glassy carbon. On the other hand, if the thickness of the SiC film of the portion coated with the SiC film is smaller than the above range, the coating of the base material made from the glassy carbon with the SiC film is insufficient, and accordingly, the coating effect by the SiC film cannot be obtained; and if the thickness exceeds the above range, generation of cracking of the SiC film results, which may occur when the formed SiC film is cooled, and originates in the difference in the coefficient of thermal expansion between the SiC film and the glassy carbon.

As a method for producing the wafer lift pin of the present invention and the SiC film-coated glassy carbon material of the present invention, the method for producing the SiC film-coated glassy carbon material of the present invention is suitably used, which will be shown below.

Examples of the method for producing the SiC film-coated glassy carbon material of the present invention includes a method (I) of: placing a base material made from glassy carbon (rod-shaped base material made from glassy carbon) to be coated with an SiC film, in a reaction apparatus for performing a CVD method; using a halogenated organic silicon compound containing an Si atom and a C atom in one molecular, for example, trichloromethylsilane (CH₃SiCl₃), dichloromethylsilane (CH₃SiHCl₂), trichlorophenylsilane (C₆H₅SiCl₃) or the like, as a raw material gas; supplying the raw material gas into the reaction apparatus together with hydrogen gas of a carrier gas, and making the raw material gas to cause gas phase reduction and thermal decomposition; thereby depositing SiC on the surface of the base material made from the glassy carbon (rod-shaped base material made from glassy carbon); and coating the surface of the base material made from the glassy carbon (rod-shaped base material made from glassy carbon) with the SiC film to obtain the SiC film-coated glassy carbon material. Then, in the production method of (I), the SiC film-coated glassy carbon material of the present invention (wafer lift pin of the present invention) can be produced by the processes of: performing the deposition reaction of SiC until the thickness of the SiC film reaches 3.0 to 10.0 µm, and preferably becomes 3.0 to 5.0 µm, while adjusting the reaction temperature to 1145 to 1185°C; or performing the deposition reaction of SiC until the time when the entire surface of the base material in an observation visual field is coated with the SiC particles, when the surface of the SiC film is observed with a scanning electron microscope, and also a ratio of the observed area of the small SiC particles having a particle diameter of 2.00 µm or smaller to the total area coated with the SiC film in the observation visual field reaches 50% or more, and preferably 70% or more, while adjusting the reaction temperature to 1145 to 1185°C. The raw material gas in the production method (I) is preferably trichloromethylsilane (CH₃SiCl₃).

Examples of the method for producing the SiC film-coated glassy carbon material of the present invention includes a method (II) of: placing a base material made from glassy carbon (rod-shaped base material made from glassy carbon) to be coated with an SiC film, in a reaction apparatus for performing a CVD method; using a silicon compound such as silicon tetrachloride (SiCl₄) and a carbon-containing compound such as methane (CH₄), as raw material gases; supplying the raw material gases into the reaction apparatus together with hydrogen gas or argon gas of a carrier gas, making the raw material gases to cause a gas phase reaction; thereby depositing SiC on the surface of the base material made from the glassy carbon (rod-shaped base material made from glassy carbon), and coating the surface of the base material made from the glassy carbon (rod-shaped base material made from glassy carbon) with the SiC film to obtain the SiC film-coated glassy carbon material. Then, in the production method of (II), the SiC film-coated glassy carbon material of the present invention (wafer lift pin of the present invention) can be produced by the processes of: performing the deposition reaction of SiC until the thickness of the SiC film reaches 3.0 to 10.0 µm, and preferably reaches 3.0 to 5.0 µm, while adjusting the reaction temperature to 1145 to 1185°C; or performing the deposition reaction of SiC until the time when the entire surface of the base material in an observation visual field is coated with the SiC particles, when the surface of the SiC film is observed with a scanning electron microscope, and also a ratio of the observed area of the small SiC particles having a particle diameter of 2.00 µm or smaller to the total area coated with the SiC film in the observation visual field reaches 50% or more, and preferably 70% or more, while adjusting the reaction temperature to 1145 to 1185°C.

In addition, in the method for producing the SiC film-coated glassy carbon material of the present invention, when the rod-shaped base material made from the glassy carbon is coated with the SiC film, an uncoated portion can be formed at an arbitrary position, by fixing either end portion in an extending direction of the rod-shaped base material to a hole formed in a fixture for the base material over a predetermined range, and forming the SiC film by the CVD method; and a product can be obtained which utilizes the characteristics of the SiC-coated portion and the glassy carbon. In other words, the raw material gas does not enter a deep portion of the hole for fixing the base material, accordingly, the SiC film is not formed on the side of the base material abutting against the wafer, and the uncoated portion is formed at an arbitrary position. For example, due to the uncoated portion being formed on the side abutting against the wafer, the surface in contact with the wafer is designed so that the wafer avoids the contact with the hard SiC coating film and comes in contact with softer glassy carbon, and thereby the wafer lift pin can be advantageous in being capable of reducing the damage onto the wafer. On the other hand, the side surface of the lift pin becomes a coated portion, and can reduce the wear due to friction with the susceptor.

### [Example]

### (Example 1)

An SiC film-coated glassy carbon material (wafer lift pin) in which a rod-shaped base material made from glassy carbon was coated with an SiC film was obtained by operations of: inserting the rod-shaped base material made from the glassy carbon into a hole of a base material fixture by 5 mm in such a way that a portion abutting against a wafer pointed a downside, and placing the base material in a CVD method reaction apparatus; supplying trichlorosilane (CH₃SiCl₃) as a raw material gas into the reaction apparatus together with hydrogen gas of a carrier gas, in such a way that a volumetric ratio of CH₃SiCl₃ in a mixture gas of CH₃SiCl₃ and H₂ becomes 7.5% and a supplying rate of CH₃SiCl₃ also becomes 280 L/min; subjecting the mixture gas to a reaction at 1165°C for 5 minutes, and thereby forming an SiC film on the surface of the base material; and cooling the base material to room temperature.

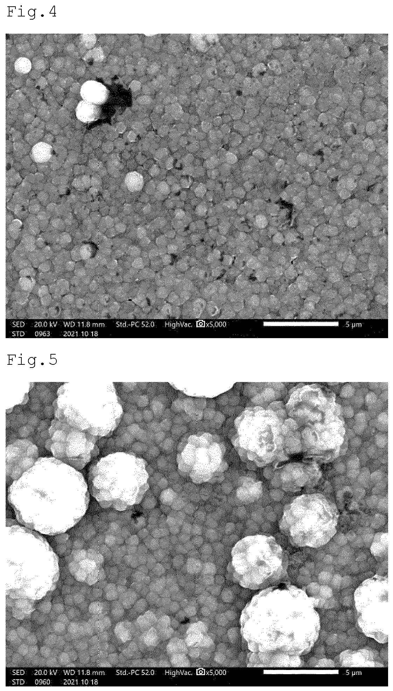

The presence or absence of cracks in the SiC film of the obtained SiC film-coated glassy carbon material (wafer lift pin) was visually checked. In addition, the obtained SiC film-coated glassy carbon material (wafer lift pin) was subjected to analysis of the SiC film at a position of 5 mm and a position of 25 mm in an extending direction from the end portion of the wafer lift pin on the side abutting against the silicon wafer. The results are shown in Table 1. In addition, Figure 4 shows an SEM photograph at the position of 5 mm, and Figure 5 shows an SEM photograph at the position of 25 mm.

### · A rod-shaped base material made from glassy carbon

Thermal conductivity: 8 W/mK, Ra: 0.150 µm, bulk density: 1.50 g/cm³, three-point bending strength: 100 MPa, diameter: 3.5 mm, and length: 60 mm

### (Comparative Example 1)

A wafer lift pin was prepared in the same way as in Example 1 except that the reaction time in the CVD method was changed to 3 minutes in place of the reaction time of 5 minutes in the CVD method. The results are shown in Table 1. At this time, surfaces of the formed SiC film at the position of 5 mm and the position of 25 mm from the end portion on the side abutting against the silicon wafer were observed by a scanning type electron microscope (SEM), and a portion at which the SiC film was not formed was observed at any position.

### (Comparative Example 2)

A wafer lift pin was prepared in the same way as in Example 1 except that the reaction time in the CVD method was changed to 60 minutes in place of the reaction time of 5 minutes in the CVD method. The results are shown in Table 1.

### (Comparative Example 3)

A wafer lift pin was prepared in the same way as in Example 1 except that in place of the operation of inserting the rod-shaped base material made from the glassy carbon into the hole of the base material fixture by 5 mm in such a way that the portion abutting against the wafer pointed the downside, and placing the base material in the CVD method reaction apparatus, the rod-shaped base material made from the glassy carbon was inserted into the hole of the base material fixture by 5 mm in such a way that a side opposite to the portion abutting against the wafer pointed the downside, and was placed in the CVD method reaction apparatus. The results are shown in Table 1.

### (Example 2)

An SiC film-coated glassy carbon material was prepared in the same way as in Example 1 except that in place of the operation of inserting the rod-shaped base material made from the glassy carbon into the hole of the base material fixture by 5 mm in such a way that the portion abutting against the wafer pointed the downside, and placing the base material in the CVD method reaction apparatus, a base material made from the glassy carbon having a plate shape of 50 mm × 50 mm × 5 mm was placed in the CVD method reaction apparatus. The results are shown in Table 2.

### (Comparative Example 4)

An SiC film-coated glassy carbon material was prepared in the same way as in Comparative Example 1 except that in place of the operation of inserting the rod-shaped base material made from the glassy carbon into the hole of the base material fixture by 5 mm in such a way that the portion abutting against the wafer pointed the downside, and placing the base material in the CVD method reaction apparatus, a base material made from glassy carbon having a plate shape of 50 mm × 50 mm × 5 mm was placed in the CVD method reaction apparatus. The results are shown in Table 2. At this time, the surface of the formed SiC film was observed by a scanning type electron microscope (SEM), and a portion at which the SiC film was not formed was observed at any position.

### (Comparative Example 5)

An SiC film-coated glassy carbon material was prepared in the same way as in Comparative Example 2 except that in place of the operation of inserting the rod-shaped base material made from the glassy carbon into the hole of the base material fixture by 5 mm in such a way that the portion abutting against the wafer pointed the downside, and placing the base material in the CVD method reaction apparatus, a base material made from the glassy carbon having a plate shape of 50 mm × 50 mm × 5 mm was placed in the CVD method reaction apparatus. The results are shown in Table 2.

### <Analysis and Evaluation>

### (Measurement of thickness of SiC film)

The cross section was polished, and 30 arbitrary points of visual fields in which the film and the base material were observed were directly observed with a scanning electron microscope at a magnification of 1000 times; a thickness of the film at an arbitrary one point in each of the visual fields was measured; and an average value of the measured 30 points was determined to be the film thickness.

### (Measurement of ratio of observed area of small SiC particles having particle diameter of 2.00 µm or smaller to total area coated with SiC film, and average particle diameter and standard deviation of small SiC particles)

A ratio of the observed area of the small SiC particles to the total area coated with the SiC film is determined by operations of: directly observing the surface of the formed SiC film with a scanning electron microscope at a magnification of 5000 times; measuring a total number of large particles having a particle diameter exceeding 2.00 µm; calculating an area of a circle which regards a size of the large particle as the diameter thereof; determining the totalized area to be the total area of the large particles exceeding 2.00 µm; calculating a percentage of the total area of the large particles to the area of the observation visual field to obtain the area ratio of the large particles; and subtracting the calculated area ratio of the large particles from 100%, based on the following expression. Ratio (%) of observed area of small SiC particles to total area coated with SiC film = 100-((total area of large particles / area of observation visual field) × 100)

The average particle diameter and standard deviation of the small SiC particles are measured by operations of: directly observing the surface of the formed SiC film with a scanning electron microscope at a magnification of 5000 times; randomly selecting 30 points of small particles having a diameter of 2.00 µm or smaller so that the intervals become almost equal; measuring diameters of the small particles; and determining an average value of the 30 points to be an average particle diameter of the small particles. Similarly, the standard deviation of 30 points is determined to be the standard deviation of small particles.

### (Measurement of surface roughness Ra)

The surface roughness Ra of a portion coated with the SiC film was measured with a SURFTESTS J-210 manufactured by Mitsutoyo Corporation, under conditions of a measurement length of 5 mm and a cut-off value of 0.8 mm, and an average value of measurements of 5 times.

### (Actual machine test)

In a semiconductor production apparatus for epitaxial film-forming treatment, a wafer lift pin was installed, and epitaxial film-forming treatment was performed 10 times. Next, the sliding portion of the wafer lift pin with the inner side of the insertion hole of the susceptor after ten uses was visually observed, and the presence or absence of the occurrence of wear was checked. For information, the presence or absence of the wear of the wafer lift pin was evaluated as "absent" when no wear was visually confirmed in the sliding portion, and as "occurrence" when the wear was visually confirmed in the sliding portion.

In addition, for the silicon wafers which were subjected to the all ten epitaxial film-forming treatments, the portions in contact with the wafer lift pin were visually observed, and the presence or absence of damages was checked. For information, the occurrence of the damage on the silicon wafer was evaluated as "absent" when the damage was not visually observed on the portion in contact with the wafer lift pin for all the ten silicon wafers, and as "occurrence" when the damage was observed on the portion in contact with the wafer lift pin, even in one of the ten silicon wafers.

### (Strength test of coating)

The coated surface was rubbed 100 times with a sapphire rod, and the occurrence of the damage on the coated surface was observed.

**[Table 1]**

| | | Example 1 | Comparativ e Example 1 | Comparative Example 2 | Comparative Example 3 |
|---|---|---|---|---|---|
| Portion coated with SiC film | | | | | |
| a) Position at 5 mm | | | | | |
| | Thickness of SiC film (µm) | 3.1 | 2.3 | 50.7 | 6.8 |
| | Area ratio of small SiC particles (%) | 100 | - | 0 | 50 |
| | Average particle diameter of small SiC particles (µm) | 0.88 | 0.81 | - | 0.94 |
| | Standard deviation of particle diameters of small SiC particles | 0.09 | 0.17 | - | 0.18 |
| | Surface roughness Ra (µm) | 0.321 | 0.304 | 1.224 | 0.428 |

| b) Position at 25 mm | | | | | |
|---|---|---|---|---|---|
| | Thickness of SiC film (µm) | 4.1 | 2.8 | 50.9 | 6.8 |
| | Area ratio of small SiC particles (%) | 70 | - | 0 | 50 |
| | Average particle diameter of small SiC particles (µm) | 0.89 | 0.83 | - | 0.95 |
| | Standard deviation of particle diameters of small SiC particles | 0.14 | 0.22 | - | 0.21 |
| | Surface roughness Ra (µm) | 0.421 | 0.356 | 1.243 | 0.431 |

| Portion uncoated with SiC film | | | | | |
|---|---|---|---|---|---|
| | Formed length (mm) | 2 | 2 | 2 | 0 |

| Product properties | | | | | |
|---|---|---|---|---|---|
| | Crack after SiC film formation | None | None | Occurrence | None |
| | Wear of lift pin after 10 uses | None | Occurrence | None | None |
| | Occurrence of damage of silicon wafer caused by lift pin | None | None | None | Occurrence |

In Table 1, a) 5 mm position is a position at 5 mm from the end portion on the side abutting against the silicon wafer in the extending direction; and b) 25 mm position is a position at 25 mm from the end portion on the side abutting against the silicon wafer in the extending direction. An area ratio (%) of the small SiC particles is a ratio (%) of an observed area of the small SiC particles having a particle diameter of 2.00 µm or smaller to the total area coated with the SiC film, in an observation visual field at the time when the surface of the SiC film has been observed by a scanning electron microscope. A length in which a portion uncoated with the SiC film is formed is a length in which the portion uncoated with SiC is formed, from the end portion on the side abutting against the silicon wafer in the extending direction.

In addition, the presence or absence of cracks after the SiC film was formed was evaluated as "absent" when a crack was not visually observed even in one portion in the SiC film, and as "occurrence" when a crack was visually observed even in one portion in the SiC film.

For information, as for the area ratio of the small SiC particles in Comparative Example 1, the area ratio of the small SiC particles could not be calculated, because a portion at which the SiC film was not formed was observed at any of the position of 5 mm and the position of 25 mm from the end portion on the side abutting against the silicon wafer.

In Example 1, in both positions of 5 mm and 25 mm from the end portion on the side abutting against the silicon wafer, the "ratio (%) of the observed area of small SiC particles having a particle diameter of 2.00 µm or smaller to the total area coated with the SiC film, in the observation visual field of the surface of the SiC film which was observed by a scanning electron microscopy" and "thickness of SiC film" were included in a range specified in the present invention; and when the formed SiC film was cooled, cracks did not occur in the SiC film; and in the actual machine test, even after 10 uses, the wear did not occur in the sliding portion with the inner side of the insertion hole of the susceptor, and also, damages did not occur in the silicon wafer due to the contact with the wafer lift pin.

On the other hand, in Comparative Example 1, the reaction time was too short, and a sufficient SiC film was not formed; and thereby, after 10 uses, the wear occurred in the sliding portion with the inner side of the insertion hole of the susceptor. In Comparative Example 2, the reaction time was too long: accordingly, the thickness of the formed SiC film became too large, and in addition, the SiC film was formed of large particles having a particle diameter exceeding 2.00 µm; and generation of cracks in the SiC film resulted when the formed film was cooled. In Comparative Example 3, the SiC film was formed in the range specified in the present invention, but the SiC film was formed on the portion abutting against the silicon wafer, and accordingly, damage occurring on the silicon wafer resulted.

**[Table 2]**

| | | Example 2 | Comparative Example 4 | Comparative Example 5 |
|---|---|---|---|---|
| Portion coated with SiC film | | | | |
| | Thickness of SiC film (µm) | 4.2 | 2.1 | 50.2 |
| | Area ratio of small SiC particles (%) | 70 | - | 0 |
| | Average particle diameter of small SiC particles (µm) | 0.90 | 1.10 | - |
| | Standard deviation of particle diameters of small SiC particles | 0.18 | 0.17 | - |
| | Surface roughness Ra (µm) | 0.422 | 0.375 | 1.232 |

| Product properties | | | | |
|---|---|---|---|---|
| | Crack after SiC film formation | None | None | Occurrence |
| | Occurrence of damage caused by coating strength test | None | Occurrence | None |

For information, as for the area ratio of the small SiC particles in Comparative Example 4, a portion at which the SiC film was not formed was observed in observation of the SiC film by SEM, and accordingly, the area ratio of the small SiC particles could not be calculated.

In Example 2, the base material was coated with the SiC film in the same way as in Example 1, and thereby cracks did not occur when the formed SiC film was cooled, and the wear such as the occurrence of the damage was not observed in the strength test of the coated portion. On the other hand, in Comparative Example 4, the film-forming time was short similarly as in Comparative Example 1, and accordingly a sufficient SiC film was not formed; because of this, the occurrence of the damage was observed in the strength test of the coated portion; and it was understood that the occurrence of wear was unavoidable in the actual use. In Comparative Example 5, similarly as in Comparative Example 2, the reaction time was too long: accordingly, the thickness of the formed SiC film became too large, and in addition, the SiC film was formed of large particles having a particle diameter exceeding 2.00 µm; and cracks occurring in the SiC film when the formed film was cooled resulted.

### [Reference Signs List]

- 1: semiconductor production apparatus
- 2: silicon wafer
- 3: susceptor
- 4: susceptor support pin
- 5: susceptor support column
- 6: supply pipe
- 7 and 21: wafer lift pin
- 8: wafer lift support column
- 9: exhaust pipe
- 10: side wall
- 11: lower outer wall
- 12: outer column
- 13: heating lamp
- 14: treatment chamber
- 15: upper plate
- 16: raw material gas
- 17: exhaust gas
- 22: rod-shaped base material
- 23: head portion for abutment
- 24: SiC film
- 25: portion coated with SiC film
- 26: portion uncoated with SiC film
- 27: portion abutting against silicon wafer
- 28: side opposite to side abutting against silicon wafer
- 29: sliding portion
- 30: end portion of SiC film on side abutting against silicon wafer
- 51: pin receiving portion of susceptor support column
- 52: vertical portion of susceptor support column
- 81: pin receiving portion of wafer lift support column
- 82: vertical of wafer lift support column

## Claims

1. A wafer lift pin that is inserted in an insertion hole of a susceptor in a semiconductor production apparatus so as to be movable in a vertical direction and is used for lifting a silicon wafer placed on the susceptor, comprising:
a rod-shaped base material made from glassy carbon; and an SiC film that is formed by a CVD method and coats a surface of the base material, wherein
at least a sliding portion with an inner side of the insertion hole of the susceptor is coated with the SiC film;
when a surface of the SiC film is observed with a scanning electron microscope, a surface of the wafer lift pin in an observation visual field is entirely coated with SiC particles, and a ratio of an observed area of small SiC particles having a particle diameter of 2.00 µm or smaller to a total area coated with the SiC film in the observation visual field is 50% or more; and
a portion abutting against the silicon wafer is not coated with the SiC film.

2. The wafer lift pin according to claim 1, wherein the small SiC particles have an average particle diameter of 0.60 to 1.60 µm, and a standard deviation of the particle diameters is 0.20 µm or smaller.

3. The wafer lift pin according to claim 1 or 2, wherein the SiC film has a thickness of 3.0 to 10.0 µm.

4. The wafer lift pin according to any one of claims 1 to 3, wherein in the SiC film, a ratio of an observed area of the small SiC particles to a total area coated with the SiC film on a side abutting against the silicon wafer is larger than a ratio of the observed area of the small SiC particles to a total area coated with the SiC film on a side opposite to the side abutting against the silicon wafer.

5. The wafer lift pin according to any one of claims 1 to 4, wherein in the SiC film, the SiC film on a side abutting against the silicon wafer is thinner than the SiC film on a side opposite to the side abutting against the silicon wafer.

6. A wafer lift pin that is inserted in an insertion hole of a susceptor in a semiconductor production apparatus so as to be movable in a vertical direction and is used for lifting a silicon wafer placed on the susceptor, comprising:
a rod-shaped base material made from glassy carbon; and an SiC film that is formed by a CVD method and coats a surface of the base material, wherein
at least a sliding portion with an inner side of the insertion hole of the susceptor is coated with the SiC film;
the SiC film has a thickness of 3.0 to 10.0 µm; and
a portion abutting against the silicon wafer is not coated with the SiC film.

7. The wafer lift pin according to claim 6, wherein in the SiC film, the SiC film on a side abutting against the silicon wafer is thinner than the SiC film on a side opposite to the side abutting against the silicon wafer.

8. An SiC film-coated glassy carbon material comprising: a base material made from glassy carbon; and an SiC film that is formed by a CVD method and coats a surface of the base material, wherein
when a surface of the SiC film is observed with a scanning electron microscope, the surface of the base material in an observation visual field is entirely coated with SiC particles, and a ratio of an observed area of small SiC particles having a particle diameter of 2.00 µm or smaller to a total area coated with the SiC film in the observation visual field is 50% or more.

9. An SiC film-coated glassy carbon material comprising: a base material made from glassy carbon; and an SiC film that is formed by a CVD method and coats a surface of the base material, wherein
the SiC film has a thickness of 3.0 to 10.0 µm.
